# FASCICULE DE BREVET EUROPEEN

(11) **EP 1 860 778 B1**
(45) Date de publication et mention de la délivrance du brevet: **25.03.2009**
(21) Numéro de dépôt: 07108587.2
(22) Date de dépôt: 22.05.2007
(51) Int. Cl.: H03M 1/18, H03M 1/60

(54) **Dispositif microelectronique convertisseur analogique/numerique a equilibrage de charges ameliore**
Mikroelektronische Analog-Digital-Wandlervorrichtung mit verbessertem Ladungsausgleich
Micro-electronic analogue-to-digital converter with improved charge balancing

(30) Priorité: 24.05.2006 FR 0604718
(43) Date de publication de la demande: 28.11.2007
(73) Titulaire: COMMISSARIAT A L'ENERGIE ATOMIQUE, 75752 Paris Cedex 15 (FR)
(72) Inventeur: PEIZERAT, Arnaud, 38000, GRENOBLE (FR)
(74) Mandataire: Poulin, Gérard

(56) Documents cités:
- FR-A1- 2 330 213
- CIRIO R ET AL: "A 64-Channel Wide Dynamic Range Charge Measurement ASIC for Strip and Pixel Ionization Detectors" IEEE TRANSACTIONS ON NUCLEAR SCIENCE, IEEE SERVICE CENTER, NEW YORK, NY, US, vol. 52, no. 4, août 2005 (2005-08), pages 847-853, XP011137748 ISSN: 0018-9499

## Description

### DOMAINE TECHNIQUE

L'invention est relative au domaine des capteurs microélectroniques imageurs ou capteurs d'image, notamment en technologie CMOS. L'invention concerne un dispositif microélectronique doté d'un ou plusieurs pixels, comprenant respectivement, un détecteur, et un convertisseur analogique/numérique, en particulier asynchrone et à injection de charge modulable.

L'invention concerne également un procédé de commande d'un tel dispositif. L'invention permet notamment d'obtenir une dynamique de conversion améliorée.

### ART ANTERIEUR

Un dispositif microélectronique imageur ou capteur d'image est généralement formé d'une matrice de pixels et d'un dispositif électronique de contrôle. Chaque pixel comprend un détecteur, doté par exemple d'au moins une photodiode ou d'au moins un phototransistor, prévu(e) pour convertir l'énergie de photons incidents sur le pixel en paires électrons-trous, d'une capacité d'intégration, dont le rôle est de stocker ces charges, ainsi que d'un ou plusieurs transistors. En sortie, la matrice de pixels délivre un signal analogique, que le dispositif de contrôle est susceptible de convertir en signal numérique. La conversion analogique/numérique peut être éventuellement effectuée à l'intérieur de la puce dans laquelle la matrice de pixels est intégrée.

Le document US 5 461 425 présente un imageur doté d'une matrice de pixels délivrant des signaux analogiques et d'une pluralité de convertisseurs analogique/numérique intégrés sur une même puce de circuit intégré que la matrice de pixels, chaque convertisseur analogique/numérique étant associé à un ou plusieurs pixels, par exemple à un groupe de 4 pixels. Un dispositif microélectronique de numérisation divulgué dans ce document est illustré sur la figure 1. Ce dispositif de numérisation est formé d'un modulateur ΔΣ synchrone 2, comprenant un condensateur d'intégration 1 destiné à recevoir des charges, sous forme d'un courant Idet, issu du photo-détecteur, un comparateur 3 piloté par une horloge 4. Le comparateur 3 commande un injecteur de charges 6 relié à une sortie du comparateur 3 et destiné à injecter des paquets de charges dans le condensateur 1, en entrée du comparateur 3. Du modulateur ΔΣ 2 est issu un train de bits qui peut être filtré à l'aide d'un filtre numérique 8, par exemple un filtre décimateur situé à l'extérieur d'une puce dans laquelle la matrice de pixels et le dispositif de numérisation sont intégrés. Un tel dispositif de numérisation présente typiquement une bonne linéarité, mais ne permet généralement d'atteindre qu'une résolution relativement faible.

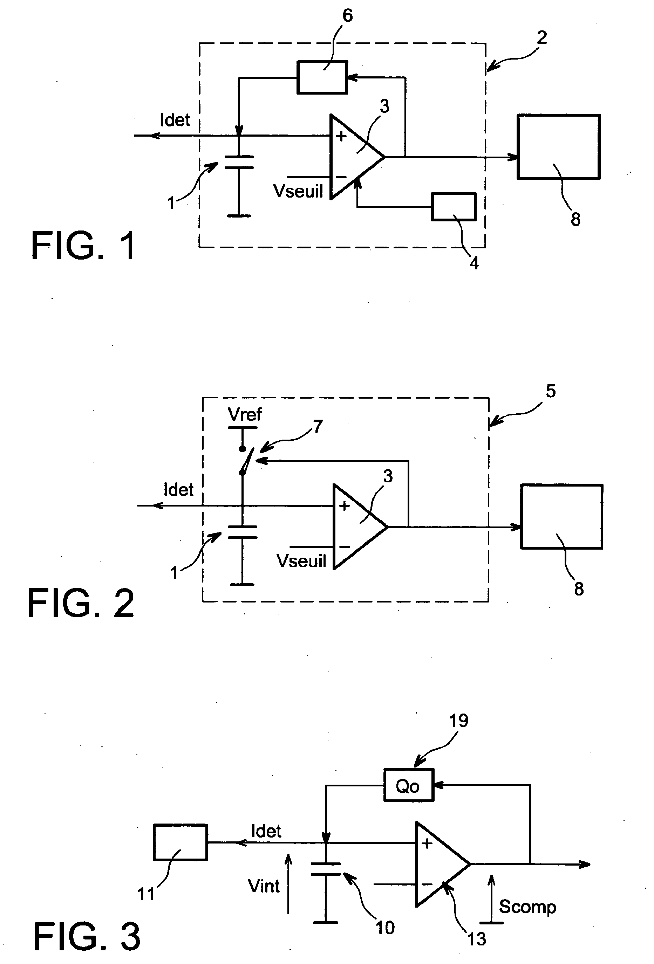

Le document de L. G. McIlrath : « A Low Power Low-Noise Ultrawide-Dynamic Range CMOS Imager With Pixel-Parallel A/D Conversion », IEEE, JSSCC, vol. 36, n°5, Mai 2001, divulgue une variante de dispositif de numérisation intégré à un pixel d'un imageur, doté d'un modulateur ΔΣ 5 asynchrone, est illustré sur la figure 2. Ce modulateur ΔΣ 5 comprend un comparateur 3, qui commande un interrupteur 7 de remise à niveau à une tension de référence Vref. Du modulateur ΔΣ 5 est issu un train de bits qui peut être également transmis à un filtre numérique 8 (figure 2). Un tel dispositif permet d'obtenir une très grande dynamique, par exemple de l'ordre de 15 à 17 bits. En revanche, la numérisation opérée est dépendante de la linéarité de la capacité d'intégration 1 et présente une linéarité insuffisante notamment lorsque le courant détecteur Idet issu du photo-détecteur est important.

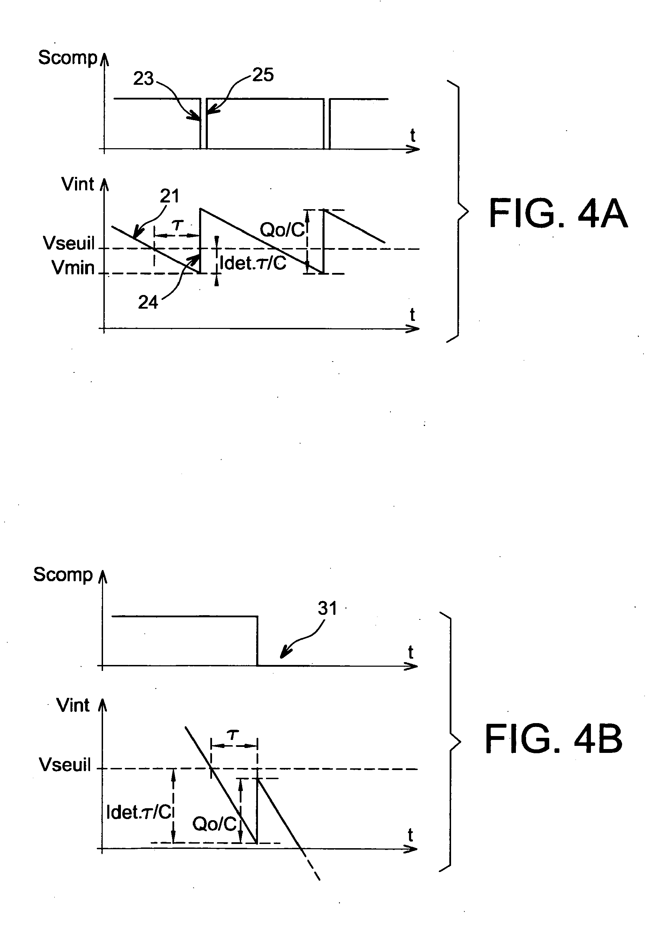

Un autre type de dispositif convertisseur analogique numérique, dit « à équilibrage de charges », intégré à un imageur est donné dans le document : « A 64-channel wide dynamic range charge measurement ASIC for strip and pixel ionization detectors », Mazza et al. , IEEE, trans. On nuclear science vol. 52 n°4 August 2005 ». Ce dispositif comprend un condensateur d'intégration 10 en sortie d'un détecteur 11 et relié à une entrée d'un comparateur 13, ainsi qu'un injecteur de charges 19. Un mode de fonctionnement de ce dispositif de numérisation est illustré sur la figure 4A représentant des exemples de signaux Scomp en sortie du comparateur 13 et Vint en entrée du comparateur 13, en particulier pour un courant de détection Idet appartenant à une première gamme de courants dits « faibles » ou/et tels que I_{DET} τ < Qₒ, avec τ une constante de retard de basculement du comparateur 13 et Qo la quantité de charge fixe susceptible d'être déversée dans le condensateur 10 par l'injecteur 19. Selon ce mode de fonctionnement, lorsque le condensateur d'intégration 10 reçoit des charges issues du détecteur, la tension Vint ou le signal analogique Vint varie, par exemple décroît (une telle variation étant illustrée par exemple par une portion de courbe décroissante 21 sur la figure 4A). L'ampleur de cette variation, dépend de l'intensité du courant de détection Idet. Puis, suite à cette variation, le signal analogique ou la tension Vint atteint un certain seuil, par exemple passe en dessous d'une tension de seuil Vseuil du comparateur 13. Un temps de retard noté τ après l'atteinte du seuil Vseuil, le signal Scomp en sortie du comparateur 13 bascule. Lors de ce basculement, le signal Scomp en sortie du comparateur 13 passe d'un premier état dit état « stable », par exemple un état haut, à un deuxième état, par exemple un état bas. Un tel basculement est représenté, par exemple par un front descendant 23 sur la figure 4A. Le changement d'état du signal Scomp déclenche une injection, par l'injecteur 19, d'une quantité de charges fixe Q₀. Une telle injection de charge peut se traduire par exemple par une hausse du signal Vint (portion verticale de courbe référencée 24 sur la figure 4A) d'une valeur de l'ordre de Q_{o/}C. Sur la figure 4A, la hausse du signal Vint provoquée par l'injection, est telle que ce signal Vint atteint une valeur supérieure à la tension de seuil du comparateur 13 et suffisante pour permettre à la sortie du comparateur de basculer à nouveau ou au signal Scomp de passer du deuxième état au premier état (front montant référencé 25) ou de repasser à l'état stable. Dans ce premier mode de fonctionnement, le signal Scomp en sortie du comparateur 13 retrouve son état stable ou repasse dans le premier état après chaque injection de charge. Le nombre d'injections que l'injecteur 19 a réalisé pour équilibrer les charges en provenance du détecteur 11 peut permettre de donner une valeur numérique représentative de la quantité de charges totale issues du détecteur 11.

Avec un tel dispositif, la numérisation est sensible à la rapidité du comparateur 13, qui peut, s'il est trop lent, par exemple si la constante de temps *τ* est telle que : τ > (Q_{O}/I_{DET}), provoquer un blocage d'une numérisation en cours. Un tel blocage est illustré sur la figure 4B (portion 31 de la courbe représentative du signal Scomp de sortie du comparateur bloquée dans le deuxième état ou à l'état bas).

Il se pose le problème de trouver un nouveau dispositif de conversion analogique-numérique intégré à un pixel d'un imageur et comportant à la fois une bonne linéarité et une bonne dynamique de conversion, et qui ne présente pas les inconvénients mentionnés plus haut.

### EXPOSÉ DE L'INVENTION

L'invention concerne tout d'abord un dispositif microélectronique comprenant: au moins un détecteur formé, d'au moins un condensateur d'intégration associé au détecteur et apte à délivrer au moins un signal analogique susceptible de varier au moins en fonction d'un courant délivré par le détecteur, et des moyens de conversion analogique/numérique comportant :
- un comparateur apte à recevoir un signal analogique du condensateur d'intégration et à délivrer un signal de sortie à deux états susceptible d'adopter, en fonction du signal analogique, un premier état dit « état stable » ou un deuxième état,
- des moyens injecteurs de charges aptes à modifier le signal analogique par au moins une injection d'une quantité de charges donnée Qc dans ledit condensateur consécutivement à un changement d'état en sortie dudit comparateur, du premier état vers le deuxième état,
- des moyens de commande des moyens injecteurs de charges, les moyens de commande étant aptes à moduler la quantité de charge donnée Qc en fonction de l'intensité dudit courant.

Le dispositif microélectronique peut être un capteur d'image. Le détecteur peut être formé d'au moins un élément photo-détecteur.

Les moyens de commande des moyens injecteurs de charges peuvent être prévus pour recevoir le signal à deux états.

L'invention permet d'obtenir une dynamique de conversion plus étendue.

L'invention permet de ne pas avoir à prévoir avant ou lors d'une prise d'image, quelle gamme d'intensité lumineuse ou quel calibre doit être utilisé.

Selon une mise en oeuvre possible, les moyens injecteurs de charges peuvent être formés d'une pluralité d'injecteurs de charges.

Selon une variante, les moyens injecteurs de charges peuvent être sous forme d'au moins un transistor commandé par une tension. Selon cette variante, les moyens de commande des moyens injecteurs sont susceptibles de moduler la quantité de charge donnée Qc en faisant varier ladite tension appliquée audit transistor.

Selon une autre variante, les moyens injecteurs sont susceptibles d'injecter une quantité de courant I fixe dans le condensateur d'intégration selon une durée Tinj d'injection variable, telle que Qc = I*Tinj.

Selon une possibilité de mise en oeuvre du dispositif microélectronique capteur d'images, dans laquelle les moyens injecteurs de charges sont formés d'une pluralité d'injecteurs de charges, lors d'une succession d'injections de charges, les moyens de commande peuvent être prévus pour activer un premier injecteur de charge ou une première pluralité d'injecteurs de charge pour effectuer une première injection de charge de valeur donnée, et pour activer un injecteur différent du premier injecteur ou une pluralité d'injecteurs différente de la première pluralité d'injecteurs, pour effectuer au moins une autre injection de charge de valeur égale à ladite valeur donnée.

Selon une variante de mise en oeuvre dans laquelle les moyens injecteurs de charges sont formés d'une pluralité d'injecteurs de charges, et dans laquelle les moyens de commande sont prévus pour, à chaque injection de charge d'une série d'injections de charge, activer au moins un ou plusieurs injecteur(s) différent(s) de l'injecteur de charge ou des injecteurs de charge activés lors de l'injection de charge précédente.

L'invention peut ainsi permettre de limiter les effets de dispersions technologiques.

Selon une possibilité de mise en oeuvre, les moyens injecteurs peuvent être formés d'une pluralité d'injecteurs identiques, aptes respectivement à injecter une quantité de charge fixe élémentaire Qo.

Le dispositif microélectronique capteur d'image selon l'invention peut éventuellement, comprendre en outre : des moyens de comptage comportant une pluralité de bascules, les moyens de commande des moyens injecteurs de charges, étant aptes à déclencher, pour chaque injection de charge Qc, une modification de la sortie d'au moins une bascule donnée sélectionnée parmi lesdites bascules, ladite bascule donnée ayant été sélectionnée en fonction de la quantité de charges Qc injectée.

Selon une possibilité de mise en oeuvre, les moyens de commande peuvent être prévus pour adapter la quantité de charge Qc destinée à être injectée lors d'au moins une injection de charge donnée, au moins en fonction d'une fréquence d'injections de charges effectuées préalablement à ladite injection de charge donnée.

Selon une autre possibilité de mise en oeuvre, les moyens de commande peuvent être prévus pour adapter la quantité de charge Qc destinée à être injectée lors d'au moins une injection de charges donnée, au moins en fonction du niveau minimal dudit signal analogique.

Selon une variante de mise en oeuvre, le dispositif microélectronique capteur d'image suivant l'invention, peut comprendre des moyens formant un monostable aptes à :
- identifier au moins un changement d'état du signal en sortie du comparateur, du premier état vers le deuxième état,
- émettre vers les moyens de commande, consécutivement audit changement d'état, un ou plusieurs ordres de déclenchements d'injections de charges tant que le signal en sortie du comparateur se maintient dans le deuxième état.

De tels moyens permettent d'éviter un blocage de la conversion notamment lorsque le courant de détection est élevé.

Selon une première possibilité de cette variante, les moyens de commande peuvent être prévus en outre pour : si le nombre d'ordres de déclenchements atteint un seuil prédéterminé tandis que le signal en sortie du comparateur se maintient dans le deuxième état, augmenter la quantité de charge Qc pour au moins une injection de charge suivante.

Selon une deuxième possibilité, qui peut être combinée avec la précédente, les moyens de commande peuvent être prévus en outre pour : si le nombre donné d'ordres de déclenchements consécutifs audit changement d'état est inférieur ou égal à un seuil prédéterminé lorsque le signal en sortie du comparateur repasse dans le premier état, diminuer la quantité de charge Qc injectée pour au moins une injection de charge suivante.

Dans le dispositif microélectronique capteur d'image selon l'invention, les moyens convertisseurs analogique/numérique peuvent être dépourvus d'horloge ou être asynchrones.

L'invention concerne également un procédé de commande d'un dispositif microélectronique comprenant au moins un détecteur, au moins un condensateur d'intégration associé au détecteur et apte à délivrer au moins un signal analogique susceptible de varier au moins en fonction d'un courant délivré par le détecteur, le procédé comprenant les étapes consistant à :
- comparer le signal analogique à une référence prédéterminée et délivrer un signal à deux états représentatif de la comparaison et susceptible d'adopter un premier état dit « état stable » ou un deuxième état,
- détecter, dans ledit signal à deux états, une transition du premier état vers le deuxième état,
- injecter, consécutivement à ladite détection une ou plusieurs quantité(s) de charges Qc dans le condensateur d'intégration,
- réaliser au moins une estimation du courant délivré par le détecteur,
- réaliser une comparaison du résultat de ladite estimation à au moins un seuil prédéterminé,
- injecter, consécutivement à ladite comparaison, une ou plusieurs nouvelle(s) quantités de charges Qc données dans le condensateur, ladite ou lesdites nouvelle(s) quantités de charges Qc données ayant été adaptées en fonction du résultat de ladite étape de comparaison.

Selon une possibilité de mise en oeuvre du procédé, ladite estimation du courant délivré par le détecteur peut être réalisée au moins à l'aide d'un paramètre dudit signal analogique.

Ladite estimation peut être éventuellement réalisée au moins en fonction d'une fréquence d'injections de charges Qc.

Selon une variante, ladite estimation peut être réalisée au moins en fonction du niveau minimum du signal analogique.

Selon une mise en oeuvre possible, le procédé peut comprendre en outre, consécutivement audit changement d'état l'étape consistant à :
- émettre, sous forme d'un autre signal à deux états, un ou plusieurs ordres de déclenchements d'injections de charges tant que ledit signal à deux états en sortie du comparateur se maintient dans le deuxième état, ladite estimation du courant délivré par le détecteur étant réalisée au moins à l'aide d'un décompte du nombre d'ordres de déclenchements émis.

Selon une possibilité, si le nombre d'ordres de déclenchements atteint un seuil prédéterminé tandis que le signal en sortie du comparateur se maintient dans le deuxième état, le procédé peut comprendre en outre : une augmentation de la quantité de charge pour au moins une injection de charge suivante.

Selon une autre possibilité, si le nombre donné d'ordres de déclenchements consécutifs audit changement d'état est inférieur ou égal à un seuil prédéterminé lorsque le signal en sortie du comparateur repasse dans le premier état, le procédé peut comprendre en outre : une diminution de la quantité de charge injectée pour au moins une injection de charge suivante.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un premier exemple de dispositif suivant l'art antérieur, doté d'un convertisseur analogique numérique synchrone et à injection de charges, intégré à une matrice de pixels d'un imageur ou d'un capteur d'image,
- la figure 2 illustre un deuxième exemple de dispositif suivant l'art antérieur, doté d'un convertisseur analogique numérique asynchrone, intégré à une matrice de pixels d'un imageur ou d'un capteur d'image,
- la figure 3 illustre un troisième exemple de dispositif suivant l'art antérieur, de conversion analogique numérique asynchrone et à injection de charges, intégré à une matrice de pixels d'un imageur ou d'un capteur d'image,
- les figures 4A et 4B illustrent respectivement, à l'aide de signaux d'entrée et de sortie d'un comparateur appartenant au troisième exemple de dispositif suivant l'art antérieur, un fonctionnement normal de ce dispositif et un blocage d'une numérisation mise en oeuvre par ce dispositif,
- la figure 5 illustre un exemple de dispositif de conversion analogique numérique suivant l'invention, intégré à un pixel d'un imageur, et doté notamment de moyens injecteurs de charge, à injection de charge modulable,
- les figures 6A, 6B illustrent une modulation de la contre charge Qc injectée par un injecteur de charges d'un dispositif de numérisation suivant l'invention,
- la figure 7 illustre un autre exemple de dispositif de conversion analogique numérique suivant l'invention, intégré à un pixel d'un imageur, et doté notamment de moyens de re-déclenchement destinés à empêcher un blocage du dispositif de conversion,
- la figure 8 illustre un exemple de saturation, que les moyens de re-déclenchement d'un dispositif de conversion analogique numérique suivant l'invention sont susceptibles d'empêcher,
- la figure 9 illustre un exemple d'adaptation ou de modulation de la quantité de charges injectée par les moyens injecteurs de charge au sein d'un dispositif de conversion analogique numérique suivant l'invention, intégré à au moins un pixel d'un imageur,
- la figure 10 illustre un autre exemple d'adaptation ou de modulation de la quantité de charges injectée par les moyens injecteurs de charge au sein d'un dispositif de conversion analogique numérique suivant l'invention, intégré à au moins un pixel d'un imageur,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

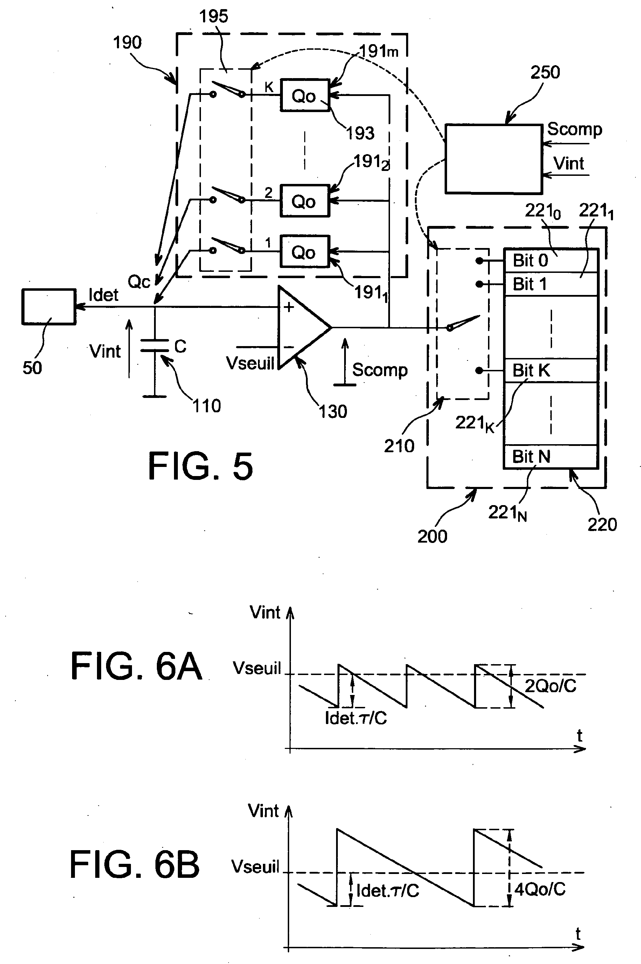

Un exemple de dispositif de numérisation ou de conversion analogique/numérique, suivant l'invention, appartenant à un dispositif microélectronique imageur ou capteur d'images, est illustré sur la figure 5. Le dispositif de numérisation est associé à un détecteur 50 d'un pixel du dispositif capteur d'images. Le dispositif de numérisation et le détecteur peuvent être intégrés à un même pixel ou/et à une même puce ou/et à un même support ou/et peuvent appartenir à un même circuit intégré. Selon une variante, le détecteur peut être assemblé ou hybridé sur le dispositif de numérisation.

Le détecteur 50 peut comprendre au moins un élément photo-détecteur, par exemple au moins une photodiode ou au moins un phototransistor (non représenté(e) sur la figure 5), prévu(e) pour convertir l'énergie de photons incidents sur le pixel en paires électrons-trous. L'élément photo-détecteur peut être prévu pour effectuer une détection d'un rayonnement électromagnétique, qui peut être par exemple visible ou de rayons X ou de rayons infrarouges.

En sortie du détecteur 50, un condensateur d'intégration 110 de capacité C, destiné à recevoir des charges issues du détecteur 50 sous forme d'un courant de détection Idet, est prévu. Le courant Idet issu du détecteur 50 peut être par exemple compris entre 100 fA et 20 nA. Aux bornes du condensateur 110 un signal analogique sous forme d'une tension Vint varie notamment en fonction du courant de détection Idet, le courant de détection Idet étant lui-même dépendant ou fonction d'une intensité lumineuse ou d'une quantité de photons reçues par le détecteur 50.

Le dispositif de numérisation est de type dit « à équilibrage de charges » et comprend en outre un comparateur 130, des moyens injecteurs 190 de charges, des moyens de comptage 200 en sortie du comparateur 130, ainsi qu'un module de commande 250 des moyens injecteurs 190 de charges et des moyens de comptage 200.

Le comparateur 130 est destiné à recevoir le signal analogique Vint sur une de ses entrées, et est prévu pour effectuer une comparaison de ce signal Vint avec une tension de seuil Vseuil. Le résultat de cette comparaison est produit en sortie du comparateur 130, sous forme d'un signal noté Scomp à deux états, susceptible d'adopter un premier état dit « état stable », qui peut être par exemple un état haut, ou un deuxième état qui peut être par exemple un état bas. Le comparateur 130 peut avoir une constante de temps τ par exemple de l'ordre de 100 ns. Le signal numérique à deux états Scomp est délivré notamment aux moyens de comptage 200.

Les moyens de comptage 200 sont situés en sortie du comparateur 130 et comprennent des moyens formant un commutateur 210 ainsi que des moyens formant un compteur 220. Le compteur 220 peut être formé d'une pluralité de bascules, par exemple de N bascules 221₀, 221₁,..., 221ₖ,..., 221_{N-1} (avec k et N des nombres entiers). Le commutateur 210 est prévu pour connecter la sortie du comparateur 130 à au moins une bascule sélectionnée parmi la pluralité de bascules 221₀, 221₁,..., 221ₖ,..., 221_{N-1}. La sortie du compteur 220 est destinée à indiquer le résultat de la conversion analogique-numérique. Les sorties des bascules 221₀, 221₁, ..., 221ₖ,..., 221_{N-1} sont associées respectivement à un bit d'une pluralité de bits Bit0,...,BitN-1.

Les moyens injecteurs 190 de charges sont situés entre la sortie du comparateur 130 et le condensateur d'intégration 110. Ces moyens injecteurs 190 de charges sont aptes, suite à une variation du courant Idet, à injecter une quantité de charges Qc ou une série de quantités de charges Qc dans le condensateur d'intégration 110. Les moyens injecteurs 190 de charges sont prévus pour modifier le signal analogique Vint par une ou plusieurs injections, respectivement d'une quantité de charges Qc donnée, dans le condensateur 110 consécutivement à un changement d'état en sortie du comparateur 130, du premier état vers le deuxième état. Dans ce dispositif, la quantité de charges également appelée « contre charge » Qc injectée par les moyens 190 peut être variable et adaptée en fonction de l'intensité du courant Idet. La contre charge Qc est de préférence telle que : Qc > Idet*τ.

Les moyens injecteurs 190 de charge peuvent être sous forme d'une pluralité de m (avec m > 0) injecteurs 191₁, ..., 191ₘ de charges comportant respectivement : des moyens de stockage 193 de charges associés à des moyens formant un interrupteur 195. Dans ce cas, la contre charge Qc est la somme des charges issues d'injecteurs sélectionnés parmi ladite pluralité d' injecteurs 191₁,..., 191ₘ. Selon une possibilité de mise en oeuvre, les moyens injecteurs 190 de charges peuvent être dotés d'un nombre m = 2^{k} (avec k un entier non nul) injecteurs de charges, activés de sorte que les différentes valeurs de contre charge Qc destinées à être injectées, sont susceptibles de suivre une progression binaire ou en 2ⁱ (avec i un entier). Les moyens injecteurs 190 de charge peuvent être formés d'une pluralité d'injecteurs de charges 191₁, ..., 191ₘ, identiques entre eux. Les moyens de stockage 193 de charges peuvent être aptes, respectivement, à emmagasiner une quantité de charge fixe élémentaire Qₒ lorsque les moyens interrupteurs 195 auxquels ces moyens de stockage 193 sont associés, sont bloqués ou ouverts ou dans un état dit « désactivé ». La charge fixe élémentaire Qₒ, peut être par exemple de l'ordre de 2000 trous ou de 0,32 fC. Les moyens de stockage 193 de charges sont susceptibles respectivement de déverser la quantité de charge fixe élémentaire Qₒ lorsque les moyens interrupteurs 195 respectifs auxquels ces moyens de stockage 193 sont associés, sont passants ou fermés ou dans un état « activé ». Les moyens injecteurs 190 peuvent modifier le signal Vint, en déversant une contre charge Qc = p*Q₀ (avec p un nombre non nul d'injecteurs de charges activés ou sélectionnés parmi les m injecteurs 191₁, ..., 191ₘ de charges) ou éventuellement une série de plusieurs contre charges consécutives respectivement égales à une quantité de charge Qc = p*Q₀, dans le condensateur 110 en entrée du comparateur 130. La quantité de charges ou la contre charge Qc injectée peut être variable d'une injection de charges à l'autre. Le nombre p d'injecteurs de charges activés ou sélectionnés parmi les m injecteurs 191₁,...,191ₘ de charges, peut être ainsi variable d'une injection de charges à l'autre. Par injecteur « activé » on entend un injecteur déversant une quantité de charge fixe Q₀ et dont l'interrupteur associé est activé ou fermé ou passant. Le dispositif est doté de moyens pour adapter la contre charge Qc issue des moyens injecteurs 190 de charge. Cette contre charge Qc peut être adaptée ou modulée en fonction de l'intensité du courant Idet issu du détecteur 50. Selon un exemple, lors d'une injection de charge, les moyens injecteurs peuvent délivrer une quantité de charge Qc par exemple égale à Qₒ, à l'aide d'un injecteur 191₁ activé, puis, lors de l'injection suivante, délivrer une quantité de charge Qc par exemple égale à 2*Q₀, à l'aide de deux injecteurs 191₁, 191₂, activés.

Pour permettre de diminuer les effets liés aux dispersions technologiques entre les différents injecteurs 191₁,..., 191ₘ, le dispositif de numérisation peut être mis en oeuvre pour que les injecteurs activés diffèrent d'une injection de charge à l'autre, ou d'une injection à l'injection suivante. Le dispositif peut être prévu notamment pour que, lors d'une succession d'injections de charges, activer un premier injecteur de charge ou une première pluralité d'injecteurs de charge pour effectuer une première injection de charge de valeur donnée, et pour activer un injecteur différent du premier injecteur ou une pluralité d'injecteurs différente de la première pluralité d'injecteurs, pour effectuer au moins une autre injection de charge de valeur égale à ladite valeur donnée. Ladite première injection et ladite autre injection peuvent être successives. Selon une alternative le dispositif peut être mis en oeuvre de sorte que lors d'une série d'injections de charges effectuées par les moyens injecteurs 190, à chaque injection de charge, au moins un injecteur de charge ou plusieurs injecteurs de charges, ou tous les injecteurs de charges, diffère(nt) de celui ou de ceux sélectionnés pour l'injection de charge précédente. Selon un exemple de fonctionnement, lors d'une injection de charge, les moyens injecteurs 190 sont susceptibles de délivrer une quantité de charge Qc par exemple égale à Qₒ, à l'aide d'un premier injecteur 191₁ activé, puis, lors de l'injection suivante, de délivrer une quantité de charge Qc par exemple égale à Qo, à l'aide d'un deuxième injecteur 191₂ activé, différent du premier injecteur 191₁.

Le module de commande 250 reçoit quant à lui en entrée, le signal Scomp à deux états de sortie du comparateur 130, ainsi que le signal Vint aux bornes du condensateur d'intégration 110. La sélection pour chaque injection, du ou des injecteurs 191₁, ..., 191ₘ destinés à déverser la contre charge Qc dans le condensateur 110, est effectuée par le module de commande 250. Le module de commande 250 peut être notamment mis en oeuvre, par exemple à l'aide d'au moins un registre à décalage, pour sélectionner, en vue d'une injection ou pour chaque injection réalisée par les moyens injecteurs 190, au moins un injecteur différent des injecteurs ou de l'injecteur sélectionné(s) lors de l'injection précédente. Dans cet exemple de réalisation le module de commande 250 est également prévu, pour sélectionner en vue de chaque injection, un nombre p d'injecteurs adapté en fonction de l'évolution du signal Vint. Le module de commande 250 peut être également prévu pour régir les interrupteurs du commutateur 210. Pour chaque injection de charges, le module de commande 250 peut effectuer une sélection, par l'intermédiaire du commutateur 210, d'une entrée du compteur 220 parmi les entrées du compteur 220, à connecter à la sortie du comparateur 130. Pour chaque injection de charges, le module de commande 250 est ainsi susceptible de déclencher une connexion d'une entrée d'une bascule parmi les entrées des bascules 211₀, 211₁, ..., 211ₖ,..., 211_{N-1}, à la sortie du comparateur 130. Pour une injection de charge donnée, la sélection d'une bascule parmi les bascules 211₀, 211₁, ..., 211ₖ,..., 211_{N-1}, est réalisée en fonction de la valeur de la contre charge Qc prévue pour cette injection de charge donnée. La sélection d'un ou plusieurs injecteurs peut être réalisée simultanément à celle d'une ou plusieurs bascules des moyens de comptage 200. Selon un exemple de fonctionnement, lorsqu'un seul injecteur est activé parmi la pluralité d'injecteurs 191₁, ..., 191ₘ, une quantité de charges QC=Q₀, est injectée, tandis que la sortie du comparateur 130 est connectée à la première bascule 221₀ du compteur 220 correspondant au 1^{er} bit Bit 0 de ladite pluralité de bits Bit 0,..., Bit N-1. Lorsque deux injecteurs sont activés parmi la pluralité d'injecteurs 191₁, ..., 191ₘ une quantité de charges QC=2*Q₀, est injectée, tandis que la sortie du comparateur 130 est connectée à la deuxième bascule 221₁ du compteur 220 correspondant au 2^{ème} bit, Bit 1 de ladite pluralité de bits Bit 0,..., Bit N-1. Lorsque k injecteurs sont activés parmi la pluralité d'injecteurs 191₁, ..., 191ₘ, une quantité de charges Qc=2^{k}*Q₀, est injectée, tandis que la sortie du comparateur 130 est connectée à la (k+1)^{ème} bascule 221ₖ du compteur 220. Le module de commande 250 est ainsi susceptible de déclencher, pour chaque injection de charge, une modification de la sortie d'au moins une bascule donnée sélectionnée parmi lesdites bascules, la bascule donnée ayant été sélectionnée en fonction de la valeur de la contre charge Qc injectée.

A la fin d'une conversion, le compteur 220 contient la valeur numérique de la quantité de charge reçue en entrée du dispositif ou du courant Idet. La précision ou bit le moins significatif (LSB pour « last significant bit ») du compteur 220 est déterminée en fonction de la valeur de la dernière contre charge Qc injectée lors de ladite conversion. Dans un cas par exemple, où la dernière injection effectuée lors d'une conversion est égale à Q₀, les N bits bit 0,..., bit N-1 du compteur 220 sont significatifs. Dans un autre cas par exemple, où la dernière injection effectuée lors d'une conversion est égale à 2*Q₀, N-1 bits du compteur 220 sont significatifs. Dans un autre cas par exemple, où la dernière injection effectuée lors d'une conversion est égale à (2^{k})*Q₀, N-K bits du compteur 220 sont significatifs.

Selon un exemple de mise en oeuvre du dispositif et en particulier des moyens de commande 250, l'adaptation de la valeur de la contre charge Qc pour une injection, peut être réalisée par ce module de commande 250 en fonction du signal Vint et en particulier de la fréquence F des injections dans ce signal Vint. Une estimation de la fréquence F des injections peut permettre d'obtenir une estimation du courant Idet issu du détecteur.

Le module de commande 250 peut être mis en oeuvre pour que lorsque la fréquence des injections F dépasse un premier seuil prédéterminé F_{seuil_haut}, tel que F_{seuil_haut} < 1/ *τ',* la contre charge Qc est augmentée, par exemple doublée, au moins pour la prochaine injection de charge et éventuellement pour les injections de charges suivantes. Dans un cas, par exemple où la contre charge courante injectée est égale à 2*Q₀ (figure 6A, un exemple de signal analogique Vint en entrée du comparateur 130 étant représenté sur cette figure) et que la fréquence des injections F atteint ou dépasse le premier seuil donné F_{seuil_haut}, le module de commande 250 peut sélectionner deux injecteurs supplémentaires pour la prochaine injection de charge de sorte que la prochaine contre charge est égale à 4*Q₀ (figure 6B, représentative du signal Vint en entrée du comparateur 130). Un deuxième seuil peut être également mis en oeuvre pour que lorsque la fréquence des injections F atteint ou passe en dessous d'un deuxième seuil donné F_{seuil_bas}, la contre charge Qc est diminuée, par exemple divisée par 2. Dans un cas par exemple où la contre charge courante injectée est égale à 4*Q₀ (figure 6B) et que la fréquence des injections F passe en dessous du deuxième seuil donné F_{bas}, le module de commande 250 peut sélectionner deux injecteurs en moins pour la prochaine injection de charge de sorte que la prochaine contre charge est égale à 2*Q₀ (figure 6A).

Selon un autre exemple de mise en oeuvre du dispositif et en particulier des moyens de commande 250, l'adaptation du nombre p d'injecteurs sélectionné par le module de commande 250 ou de la valeur de la contre charge Qc injectée, peut être réalisée en fonction de la valeur ou de l'amplitude de la tension d'intégration Vint. L'adaptation de la contre charge Qc peut être réalisée en particulier en fonction du minimum Vmin qu'atteint la tension d'intégration Vint après une décharge du condensateur d'intégration 110. Le minimum Vmin de la tension d'intégration Vint donne une indication au module de commande 250 sur la valeur du produit Idet*τ . Une estimation du minimum Vmin de la tension d'intégration Vint peut permettre d'obtenir une estimation du courant Idet issu du détecteur, et permet au module de commande 250 d'adapter la valeur de la prochaine contre charge Qc en fonction de la valeur du produit Idet* τ.

Le dispositif suivant l'invention n'est pas limité à des moyens injecteurs formés d'injecteurs identiques entre eux. L'invention n'est pas non plus limitée à des valeurs de contre charge Qc suivant une progression en 2ⁱ. Une variante de dispositif pour laquelle, par exemple des contre charges Qc=3*Qₒ, sont susceptibles d'être injectées peut également être prévue. Dans une telle variante, les moyens de comptage peuvent comporter un compteur dont l'incrément est 3, et formé, par exemple, à l'aide d'au moins un additionneur.

Le dispositif microélectronique suivant l'invention n'est pas limité à des moyens injecteurs formés d'une pluralité d'injecteurs.

Selon une variante, les moyens injecteurs de charges peuvent par exemple être sous forme d'un transistor commandé par une tension, les moyens de commande des moyens injecteurs étant susceptibles de moduler la quantité de charge Qc en modulant ladite tension appliquée audit transistor.

Selon une autre variante, les moyens de commande des moyens injecteurs peuvent être prévues pour à chaque injection, injecter une quantité de courant I fixe selon une durée Tinj d'injection variable et qui peut être modulée, telle que Qc = I*Tinj.

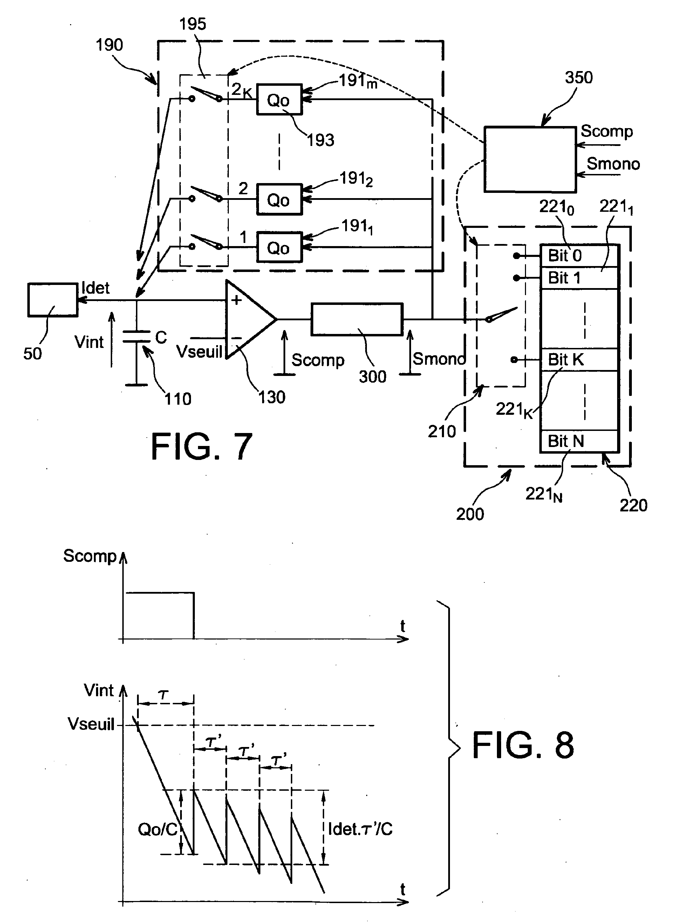

Une variante du dispositif de numérisation suivant l'invention précédemment décrit, est illustrée sur la figure 7. Pour cette variante, le dispositif de numérisation est doté en outre de moyens formant un monostable 300 dit de « re-déclenchement » situé en sortie du comparateur 130, entre ce dernier et les moyens de comptage 250. Le monostable 300 délivre un signal Smono à deux états, et est dépourvu d'horloge et/ou a un fonctionnement asynchrone. A l'aide du monostable 300, la numérisation mise en oeuvre par le convertisseur, est peu sensible à la rapidité du comparateur 130 ou au retard τ de déclenchement du comparateur 130, et permet de se prémunir d'un blocage tel qu'illustré sur la figure 4B, du signal de sortie Scomp du comparateur, lorsque le courant I_{DET} en sortie du détecteur est élevé. Le monostable 300 peut être formé par exemple d'une bascule destinée à recevoir le signal Scomp de sortie du comparateur 130, de plusieurs cellules à retard, ainsi que d'une ou plusieurs portes logiques. Le monostable 300 comprend notamment des moyens pour :
- identifier un changement d'état du signal Scomp en sortie du comparateur 130, d'un premier état ou état stable, par exemple un état haut, vers un deuxième état ou état instable, par exemple un état bas,
- émettre, par l'intermédiaire du signal Smono, consécutivement audit changement d'état, une ou plusieurs instructions de déclenchement, ou commandes de déclenchement, d'injections de charges tant que le signal Scomp en sortie du comparateur 130 se maintient dans le deuxième état ou état instable.

Pour cette variante, le module de commande 250 est remplacé par un autre module de commande noté 350. Le module de commande 350 de cette variante de dispositif, reçoit en entrée le signal de sortie Scomp du comparateur 130, ainsi que le signal Smono de sortie du monostable 300. Le module de commande 350 est prévu pour sélectionner, lorsqu'il reçoit une instruction de déclenchement ou une commande de déclenchement d'injection provenant du monostable 300, le ou les injecteurs 191₁, ..., 191ₘ destinés à déverser la quantité de charges Qc dans le condensateur 110. Le module de commande 350 est également susceptible d'effectuer pour chaque injection de contre-charge Qc, une sélection d'une entrée d'une bascule parmi les entrées des bascules 211₀, 211₁, ..., 211ₖ,..., 211_{N-1}, à relier à la sortie du comparateur 130, en fonction de la valeur prévue pour cette contre charge Qc. Le monostable 300 a une constante de temps τ'. La constante de temps τ' peut être par exemple de l'ordre de 60 nanosecondes et correspond à une durée minimale entre deux instructions de déclenchement d'injections ou entre deux commandes de déclenchement d'injections. Le dispositif suivant l'invention est mis en oeuvre pour se prémunir d'une saturation lorsque Idet* τ '> Q₀, une telle saturation étant illustrée par exemple sur la figure 8.

Pour éviter une saturation du dispositif, le module de commande 350 peut être mis en oeuvre pour effectuer un décompte du nombre Xi d'instructions de déclenchement ou de commandes de déclenchement consécutives dans le signal Smono, faisant suite à un changement d'état, du premier état vers le deuxième état, du signal Scomp en sortie du comparateur 130.

Une estimation du nombre Xi d'instructions de déclenchement peut permettre d'obtenir une estimation du courant Idet issu du détecteur.

Un nombre Xi d'instructions de déclenchement ou de commandes de déclenchement consécutives trop élevé peut indiquer au bloc de commande 350 que la contre charge Qc doit de préférence être augmentée, tandis qu'un nombre Xi d'instructions de déclenchement ou de commandes de déclenchement consécutives trop faible peut indiquer au bloc de commande 350 que la contre charge Qc doit de préférence être diminuée.

Suite à un changement d'état du signal Scomp en sortie du comparateur 130, du premier état vers le deuxième état, le module de commande 350 effectue à partir du signal Smono de sortie du monostable 300, un décompte du nombre Xi d'instructions de déclenchement ou de commande de déclenchement consécutives préalablement. Dans un cas où le nombre Xi d'instructions de déclenchement atteint un premier seuil Seuil_max prédéterminé, par exemple de 4 déclenchements, tandis que le signal Scomp de sortie du comparateur se maintient dans le deuxième état, le module de commande 350 augmente la valeur de la contre charge Qc pour l'injection de charge suivante.

Dans un autre cas, où le nombre Xi d'ordres de déclenchements consécutifs audit changement d'état est inférieur ou égale à un deuxième seuil Seuil_min prédéterminé, par exemple de 1 déclenchement lorsque le signal Scomp de sortie du comparateur 130 est repassé dans le premier état, le module de commande 350 diminue la valeur de la contre charge Qc pour l'injection de charge suivante.

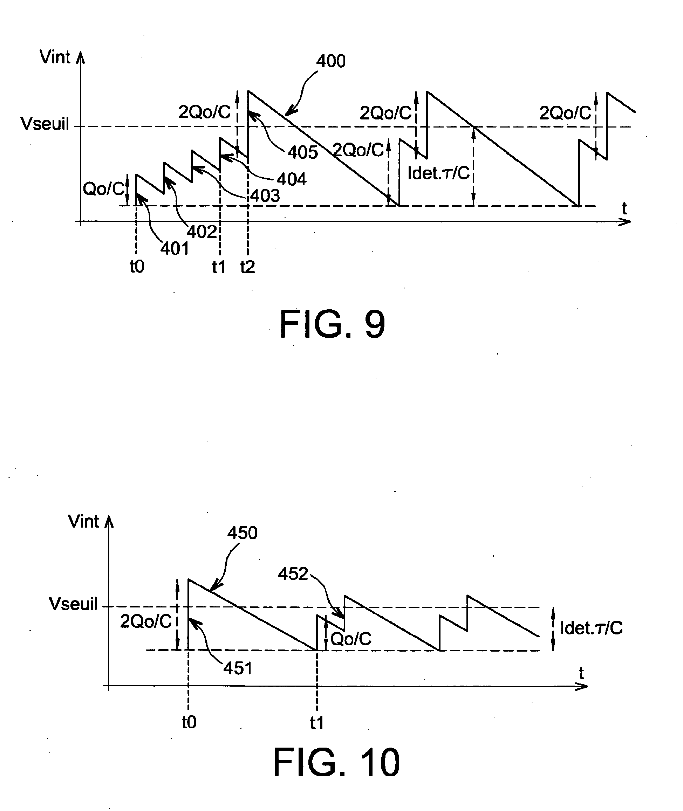

Un exemple de fonctionnement du dispositif précédemment décrit, mis en oeuvre avec un premier seuil de déclenchement Seuil_max=4, est illustré sur la figure 9, par l'intermédiaire d'une courbe 400 représentative d'un exemple de signal Vint analogique aux bornes du condensateur d'intégration 110. Suite à un changement d'état (non représenté) du signal de sortie du comparateur 130, d'un premier état ou état stable, à un deuxième état ou état instable, à un instant t₀, une première injection de charge (portion référencée 401 de la courbe 400) est réalisée par les moyens injecteurs 190 avec une contre charge Qc égale à Qₒ. Puis, plusieurs autres injections (portions référencées respectivement 402, 403, de la courbe 400) de charges respectivement égales à Qₒ sont effectuées après t₀, entre l'instant t₀ et un instant t₁, sans que la sortie du comparateur 130 ne se remettre dans l'état stable. A un instant t₁, une quatrième injection (portion référencée 404 de la courbe 400) de charge est réalisée avec une contre charge Qc égale à Q₀. A l'instant t₁, la tension Vint est inférieure à Vseuil, de sorte que le signal de sortie du comparateur 130 n'a pas rebasculé et se maintient toujours dans le deuxième état. Le seuil Seuil_max=4 ayant été atteint à l'instant t₁, le bloc de commande 350 augmente la contre charge pour l'injection suivante. L'injection suivante (portion référencée 405 de la courbe 400) est effectuée à un instant t₂, avec une contre charge Qc augmentée et égale à 2*Q₀.

Un autre exemple de fonctionnement du dispositif précédemment décrit, mis en oeuvre avec un deuxième seuil de déclenchement Seuil_min=1, est illustré sur la figure 10, par l'intermédiaire d'une courbe 450 représentative d'un exemple de signal Vint analogique aux bornes du condensateur d'intégration 110. Suite à un changement d'état (non représenté) du signal de sortie du comparateur 130, d'un premier état ou état stable, à un deuxième état ou état instable, à un instant t₀, une première injection de charge (portion référencée 451 de la courbe 450) est réalisée par les moyens injecteurs 190 avec une contre charge Qc égale à 2*Q₀. La première injection de charge à l'instant t₀, suffit à mettre à nouveau le signal Scomp de sortie du comparateur 130 dans le premier état ou état stable. Le nombre Xi de commandes d'injection émises par le monostable 300 entre ledit changement d'état avant l'instant t₀ et lorsque qu'à l'instant la sortie du comparateur 130 revient à nouveau à l'état stable, étant égal au seuil Seuil_min, le bloc de commande 350 diminue la contre charge pour l'injection de charge suivante. Ensuite, à un instant t₁, une deuxième injection (portion référencée 452 de la courbe 450) de charge est réalisée avec une contre charge Qc diminuée et égale à Q₀.

Du point de vue de la précision de la conversion analogique numérique réalisée par un dispositif suivant l'invention, dans un cas où la prise d'image est réalisée à l'aide d'un obturateur par exemple pour une détection de rayonnement visible ou dans un cas où la source du rayonnement détecté est commandée, par exemple pour une détection de rayonnement X, l'invention permet d'obtenir une dynamique de conversion améliorée tout en conservant une bonne précision.

Dans un cas par exemple où le photodétecteur 50 est éclairé pendant une durée Δt, ce dernier produit un courant Idet qui peut être important et qui nécessiterait un changement de gamme de fonctionnement du capteur d'image. Les moyens injecteurs 190, en réponse à ce courant Idet important peuvent alors injecter des contre charge Qc égales par exemple à 8*Q₀. Ensuite, après la durée Δt, le photodétecteur 50 n'est plus éclairé, de sorte que le courant Idet retombe à une très faible valeur, par exemple celle du courant d'obscurité. Le dispositif adapte alors la valeur des contre charges injectées Qc à la valeur de charge fixe élémentaire Q₀. Une précision de Qo peut être atteinte malgré le changement de gamme qui a eu lieu.

## Revendications

1. Dispositif microélectronique comprenant : au moins un détecteur, au moins un condensateur d'intégration (110) associé au détecteur et apte à délivrer au moins un signal analogique (Vint) susceptible de varier au moins en fonction d'un courant (Idet) délivré par le détecteur, et des moyens dé conversion analogique/numérique comportant :
- un comparateur (130) apte à recevoir un signal analogique (Vint) d'un condensateur d'intégration (110) et à délivrer un signal de sortie à deux états (Scomp) susceptible d'adopter, en fonction du signal analogique (Vint), un premier état dit « état stable » ou un deuxième état,
- des moyens injecteurs (190) de charges aptes à modifier le signal analogique (Vint) par au moins une injection d'une quantité de charge (Qc) donnée dans le condensateur (110) consécutivement à un changement d'état en sortie du comparateur (130), du premier état vers le deuxième état,
- des moyens de commande (250,350) des moyens injecteurs de charges (190), **caractérisé en ce que** les moyens de commande sont aptes à moduler la quantité de charge (Qc) donnée en fonction de l'intensité dudit courant (Idet).

2. Dispositif microélectronique selon la revendication 1, les moyens de commande (250,350) étant prévus pour recevoir le signal à deux états (Scomp).

3. Dispositif microélectronique selon la revendication 1 ou 2, les moyens injecteurs (190) de charges étant formés d'une pluralité d'injecteurs de charges (191₁,...,191ₘ).

4. Dispositif microélectronique capteur d'images selon l'une des revendications 1 à 3, dans lequel les moyens injecteurs (190) de charges sont formés d'une pluralité d'injecteurs de charges (191₁,...,191ₘ), et dans lequel les moyens de commande sont prévus pour, à chaque injection de charge d'une série d'injections de charge, activer au moins un ou plusieurs injecteur(s) différent(s) de l'injecteur de charge ou des injecteurs de charge activés lors de l'injection de charge précédente.

5. Dispositif microélectronique selon l'une des revendications 1 à 4, dans lequel les moyens injecteurs (190) de charges sont formés d'une pluralité d'injecteurs de charges (191₁,...,191ₘ), et dans lequel lors d'une succession d'injections de charges, les moyens de commande sont aptes à activer un premier injecteur de charge ou une première pluralité d'injecteurs de charge pour effectuer une première injection de charge de valeur donnée, et à activer un injecteur différent du premier injecteur ou une pluralité d'injecteurs différente de la première pluralité d'injecteurs, pour effectuer au moins une autre injection de charge de valeur égale à ladite valeur donnée.

6. Dispositif microélectronique selon l'une des revendications 1 à 5, dans lequel les moyens injecteurs (190) sont formés d'une pluralité d'injecteurs (191₁,..,191ₘ) identiques, aptes respectivement à injecter une quantité de charge fixe (Qo).

7. Dispositif microélectronique selon l'une des revendications 1 à 6, comprenant en outre : des moyens de comptage (200) comportant une pluralité de bascules (221₀,...,211_{N-1}), les moyens de commande (250,350) des moyens injecteurs de charges (190), étant aptes à déclencher, pour chaque injection de charge, une modification de la sortie d'au moins une bascule donnée sélectionnée parmi lesdites bascules, ladite bascule donnée ayant été sélectionnée en fonction de la quantité de charges (Qc) injectée.

8. Dispositif microélectronique selon l'une des revendications 1 à 7, dans lequel les moyens de commande (250) sont destinés à recevoir le signal analogique (vint), les moyens de commande étant prévus pour adapter la quantité de charge (Qc) destinée à être injectée lors d'au moins une injection de charges donnée, au moins en fonction d'une fréquence d'injections de charges effectuées préalablement à l'injection de charges donnée.

9. Dispositif microélectronique selon l'une des revendications 1 à 8, dans lequel les moyens de commande (250) sont destinés à recevoir le signal analogique (vint), les moyens de commande étant prévus pour adapter la quantité de charge (Qc) destinée à être injectée lors d'au moins une injection de charges donnée, au moins en fonction du niveau minimum du signal analogique (Vint).

10. Dispositif microélectronique capteur d'image selon l'une des revendications 1 à 9, comprenant en outre des moyens formant un monostable (300) aptes à :
- identifier au moins un changement d'état du signal (Scomp) en sortie du comparateur (130), du premier état vers le deuxième état,
- émettre vers les moyens de commande (350), consécutivement audit changement d'état, un ou plusieurs ordres de déclenchements d'injections de charges tant que le signal (Scomp) en sortie du comparateur (130) se maintient dans le deuxième état.

11. Dispositif microélectronique selon la revendication 10, dans lequel les moyens de commande (350) sont prévus en outre pour : si le nombre d'ordres de déclenchements atteint un seuil prédéterminé (Seuil_max) tandis que le signal (Scomp) en sortie du comparateur (160) se maintient dans le deuxième état, augmenter la quantité de charge (Qc) pour au moins une injection de charge suivante.

12. Dispositif microélectronique capteur d'image selon l'une des revendications 11 ou 12, dans lequel les moyens de commande (350) sont prévus en outre pour : si le nombre donné d'ordres de déclenchements consécutifs audit changement d'état est inférieur ou égal à un seuil prédéterminé (Seuil_min) lorsque le signal (Scomp) en sortie du comparateur (160) repasse dans le premier état, diminuer la quantité de charge (Qc) injectée pour au moins une injection de charge suivante.

13. Dispositif microélectronique capteur d'image selon l'une des revendications 1 à 12, le détecteur étant formé d'au moins un élément photodétecteur.

14. Procédé de commande d'un dispositif microélectronique comprenant au moins un détecteur, au moins un condensateur d'intégration associé au détecteur et apte à délivrer au moins un signal analogique susceptible de varier au moins en fonction d'un courant délivré par le détecteur, le procédé comprenant les étapes consistant à :
- comparer le signal analogique à une référence prédéterminée et délivrer un signal à deux états représentatif de la comparaison et susceptible d'adopter un premier état dit « état stable » ou un deuxième état,
- détecter, dans ledit signal à deux états, une transition du premier état vers le deuxième état,
- injecter, consécutivement à ladite détection une ou plusieurs quantité(s) de charges Qc dans le condensateur d'intégration,
procédé **caractérisé en ce qu'**il comprend de plus les étapes consistant à:
- réaliser au moins une estimation du courant délivré par le détecteur,
- réaliser une comparaison du résultat de ladite estimation à au moins un seuil prédéterminé,
- injecter, consécutivement à ladite comparaison, une ou plusieurs nouvelle(s) quantités de charges Qc données dans le condensateur, ladite ou lesdites nouvelle(s) quantités de charges Qc données ayant été adaptées en fonction du résultat de ladite étape de comparaison.

15. Procédé de commande selon la revendication 14, ladite estimation du courant délivré par le détecteur étant réalisée au moins en fonction d'une fréquence d'injections de charges Qc.

16. Procédé de commande selon la revendication 14, ladite estimation étant réalisée au moins en fonction du niveau minimum du signal analogique.

17. Procédé de commande selon l'une des revendications 14 à 16, comprenant en outre, consécutivement audit changement d'état:
- l'émission, sous forme d'un autre signal à deux états, d'un ou plusieurs ordres de déclenchements d'injections de charges tant que ledit signal à deux états en sortie du comparateur se maintient dans le deuxième état, ladite estimation du courant délivré par le détecteur étant réalisée au moins à l'aide d'un décompte du nombre d'ordres déclenchements émis.

18. Procédé de commande selon la revendication 17, dans lequel si le nombre d'ordres de déclenchements atteint un seuil prédéterminé tandis que le signal en sortie du comparateur se maintient dans le deuxième état, le procédé comprend en outre : une augmentation de la quantité de charge pour au moins une injection de charge suivante.

19. Procédé de commande selon la revendication 17 ou 18, dans lequel, si le nombre donné d'ordres de déclenchements consécutifs audit changement d'état est inférieur ou égal à un seuil prédéterminé lorsque le signal en sortie du comparateur repasse dans le premier état, le procédé comprend en outre : une diminution de la quantité de charge injectée pour au moins une injection de charge suivante.

## Claims

1. Microelectronic device comprising: at least one detector, at least one integration capacitor (110) associated to the detector and capable of providing at least one analogue signal capable of varying at least according to a current supplied by the detector, and analogue/digital conversion means comprising:
- a comparator (130) capable of receiving an analogue signal (Vint) from an integration capacitor (110) and of providing an output signal (Scomp) in two states capable of adopting, according to the analogue signal, a first state called the "stable state" or a second state,
- charge injector means (190) capable of modifying the analogue signal by at least one injection of a given quantity of charge (Qc) into the capacitor following a change of state at the output of the comparator, from the first state to the second state,
- command means (250, 350) for the charge injector means, wherein the command means are capable of modulating the given quantity of charge according to the intensity of said current.

2. Microelectronic device according to claim 1, wherein the command means are provided to receive the signal in two states.

3. Microelectronic device according to claim 1 to 2, wherein charge injector means (190) are formed by a plurality of charge injectors (191₁,...,191ₘ).

4. Microelectronic image sensor device according to any of claims 1 to 3, in which the charge injector means (190) are formed by a plurality of charge injectors (191₁,...,191ₘ), and in which command means are provided in order, at each charge injection of a series of charge injections, to activate at least one or more different injector(s) of the charge injector charge injectors activated during the previous charge injection.

5. Microelectronic device according to any of claims 1 to 4, in which the charge injector means (190) are formed by a plurality of charge injectors (191₁,...,191ₘ), and in which during a succession of charge injections, the command means are capable of activating a first charge injector or a first plurality of charge injectors to make a first charge injection of a given value, and of activating a different injector from the first injector or a plurality of injectors different from the first plurality of injectors, to make at least one other charge injection whose value is equal to said given value.

6. Microelectronic device according to any of claims claim 1 to 5, in which injector means (190) are formed by a plurality of identical injectors (191₁,...,191ₘ), respectively capable of injecting a fixed quantity of charge.

7. Microelectronic device according to any of claims 1 to 6, comprising moreover: counting means (200) comprising a plurality de flip flops (221₀,...,221_{N-1}), wherein the command means of the charge injector means, are capable of triggering, for each charge injection, a modification of the output of at least one given flip flop selected from said flip flops, wherein said given flip flop is selected according to the quantity of charges injected.

8. Microelectronic device according to any of claims 1 to 7, in which the command means (250) are designed to receive the analogue signal (Vint), wherein command means are provided to adapt the quantity of charge designed to be injected during at least one given charge injection (Qc), at least according to a frequency of charge injections made prior to the given charge injections.

9. Microelectronic device according to any of claims 1 to 8, in which the command means (250) are designed to receive the analogue signal, wherein the command means are provided to adapt the quantity of charge (Qc) designed to be injected during at least one given charge injection, at least according to the minimum level of the analogue signal (Vint).

10. Microelectronic image sensor device according to any of claims 1 to 9, further comprising means forming a monostable capable of:
- identifying at least one change of state of the signal at the output of the comparator, from the first state to the second state,
- emitting to the command means, following said change of state, one or more injection trigger orders as long as the signal (Scomp) at the output of the comparator remains in the second state.

11. Microelectronic device according to claim 10, in which command means (350) are provided moreover so that: if the number of trigger orders reaches a predetermined threshold while the signal (Scomp) at the output of the comparator (160) remains in the second state, they increase the quantity of charge for at least one following charge injection.

12. Microelectronic image sensor device according to claim 10 or 11, in which command means are provided moreover so that: if the given number of trigger orders following said change of state is less than or equal to a predetermined threshold when the signal at the output of the comparator (160) switches back to the first state, they reduce the quantity of charge injected for at least one following charge injection.

13. Microelectronic image sensor device according to any of claims 1 to 12, wherein the detector is formed by at least one photo detector element.

14. Method for commanding a microelectronic device comprising at least one detector, at least one integration capacitor associated to the detector and capable of providing at least one analogue signal capable of varying at least according to a current provided by the detector, the Method comprising the steps consisting of:
- comparing the analogue signal to a predetermined reference and providing a signal in two states representative of the comparison and capable of adopting a first state called the "stable state" or a second state,
- detecting, in said signal in two states, a transition from the first state to the second state,
- injecting, following said detection, one or more quantities of charges Qc into the integration capacitor,
- making at least one estimation of the current provided by the detector,
- comparing the result of said estimation to at least one predetermined threshold,
- injecting, following said comparison, one or more new given quantities of charges Qc into the capacitor, wherein said new given quantity or quantities of charges Qc have been adapted according to the result of said comparison step.

15. Method according to claim 14, wherein said estimation of the current provided by the detector is made at least according to a frequency of charge injections Qc.

16. Method according to claim 14, wherein said estimation is made at least according to the minimum level of the analogue signal.

17. Method according to any of claims 14 to 16, comprising moreover, following said change of state:
- the emission, in the form of another signal in two states, of one or more charge injection trigger orders as long as said signal in two states at the output of the comparator remains in the second state, wherein said estimation of the current provided by the detector is made at least using the countdown of the number of trigger orders emitted.

18. Method according to claim 17, in which if the number of trigger orders reaches a predetermined threshold while the signal at the output of the comparator remains in the second state, said method comprising moreover: an increase in the quantity of charge for at least one following charge injection.

19. Method of claim 17 or 18, in which, if the given number of trigger orders following said change of state is less than or equal to a predetermined threshold when the signal at the output of the comparator switches back to the first state, the Method comprises moreover: a reduction of the quantity of charge injected for at least one following charge injection.

## Patentansprüche

1. Mikroelektronische Vorrichtung, umfassend: mindestens einen Detektor, mindestens einen Integrationskondensator (110), verbunden mit dem Detektor und fähig, mindestens ein analoges Signal (Vint) zu liefern, das wenigstens in Abhängigkeit von einem durch den Detektor gelieferten Strom (ldet) variabel ist, und Analog-Digital-Wandlereinrichtungen, umfassend:
- einen Komparator (130), fähig von einem Integrationskondensator (110) ein analoges Signal (Vint) zu empfangen und ein 2-Zustände-Ausgangssignal (Scomp) zu liefern, und fähig, in Abhängigkeit von dem analogen Signal (Vint) einen "Stabilzustand" genannten ersten Zustand oder einen zweiten Zustand anzunehmen,
- Ladungsinjektionseinrichtungen (190), fähig das analoge Signal (Vint) durch wenigstens eine Injektion einer gegebenen Ladungsmenge (Qc) in den Kondensator (110) zu modifizieren, nach einem Zustandswechsel am Ausgang des Komparators (130) von dem ersten Zustand in den zweiten Zustand,
- Steuereinrichtungen (250,350) der Injektionseinrichtungen (190),
**dadurch gekennzeichnet, dass** die Steuereinrichtungen fähig sind, die gegebene Ladungsmenge (Qc) in Abhängigkeit von der Intensität des genannten Stroms (Idet) zu modulieren.

2. Mikroelektronische Vorrichtung nach Anspruch 1, bei der die Steuereinrichtungen (250,350) vorgesehen sind, das 2-Zustände-Signal (Scomp) zu empfangen.

3. Mikroelektronische Vorrichtung nach Anspruch 1 oder 2, bei der die Ladungsinjektionseinrichtungen (190) durch eine Vielzahl von Ladungsinjektoren (191₁,...,191ₘ) gebildet werden.

4. Mikroelektronische Bildsensor-Vorrichtung nach einem der Ansprüche 1 bis 3, bei der die Ladungsinjektionseinrichtungen (190) durch eine Vielzahl von Ladungsinjektoren (191₁,...,191ₘ) gebildet werden, und bei der die Steuereinrichtungen vorgesehen sind, bei jeder Ladungsinjektion einer Serie von Ladungsinjektionen wenigstens einen oder mehrere verschiedene Ladungsinjektoren oder bei der vorhergehenden Ladungsinjektion aktivierte Ladungsinjektoren zu aktivieren.

5. Mikroelektronische Vorrichtung nach einem der Ansprüche 1 bis 4, bei der die Ladungsinjektionseinrichtungen (190) durch eine Vielzahl von Ladungsinjektoren (191₁,...,191ₘ) gebildet werden, und bei der bei einer Folge von Ladungsinjektionen die Steuereinrichtungen fähig sind, einen ersten Ladungsinjektor oder eine erste Vielzahl von Ladungsinjektoren zu aktivieren, um eine erste Ladungsinjektion von gegebenem Wert durchzuführen, und einen zu dem ersten Injektor unterschiedlichen Injektor oder eine zu der ersten Vielzahl Injektoren unterschiedliche Vielzahl Injektoren zu aktivieren, um mindestens eine andere bzw. weitere Ladungsinjektion eines Werts gleich dem genannten gegebenen Wert durchzuführen.

6. Mikroelektronische Vorrichtung nach einem der Ansprüche 1 bis 5, bei der die Injektionseinrichtungen (190) von einer Vielzahl identischer Injektoren (191₁,...,191ₘ) gebildet werden, fähig jeweils eine feste Ladungsmenge (Qo) zu injizieren.

7. Mikroelektronische Vorrichtung nach einem der Ansprüche 1 bis 6, außerdem umfassend: Zähleinrichtungen (200) mit einer Vielzahl Kippstufen (221₀,...,221_{N-1}), wobei die Steuereinrichtungen (250,350) der Ladungsinjektionseinrichtungen (190) fähig sind, bei jeder Ladungsinjektion eine Modifikation des Ausgangs wenigstens einer gegebenen Kippstufe unter den genannten Kippstufen auszulösen, wobei die genannte gegebene Kippstufe in Abhängigkeit von der injizierten Ladungsmenge (Qc) selektiert worden ist.

8. Mikroelektronische Vorrichtung nach einem der Ansprüche 1 bis 7, bei der die Steuereinrichtungen (250) dazu dienen, das analoge Signal (Vint) zu empfangen, wobei die Steuereinrichtungen vorgesehen sind, bei wenigstens einer gegebenen Ladungsinjektion die zur Injektion bestimmte Ladungsmenge (Qc) anzupassen, wenigstens in Abhängigkeit von einer Injektionsfrequenz von vor der gegebenen Ladungsinjektion durchgeführten Ladungen.

9. Mikroelektronische Vorrichtung nach einem der Ansprüche 1 bis 8, bei der die Steuereinrichtungen (250) dazu dienen, das analoge Signal (Vint) zu empfangen, wobei die Steuereinrichtungen vorgesehen sind, bei wenigstens einer gegebenen Ladungsinjektion die zur Injektion bestimmte Ladungsmenge (Qc) anzupassen, wenigstens in Abhängigkeit von dem minimalen Pegel des analogen Signals (Vint).

10. Mikroelektronische Bildsensor-Vorrichtung nach einem der Ansprüche 1 bis 9, mit außerdem eine Monostufe (300) bildenden Einrichtungen, fähig:
- wenigstens einem Zustandswechsel des Signals (Scomp) vom ersten Zustand in den zweiten Zustand am Ausgang des Komparators (130) festzustellen,
- anschließend an den genannten Zustandswechsels ein oder mehrere Befehle zur Auslösung von Ladungsinjektionen zu senden, solange das Signal (Scomp) am Ausgang des Komparators (130) den zweiten Zustand aufrechterhält.

11. Mikroelektronische Vorrichtung nach Anspruch 10, bei der die Steuereinrichtungen (350) außerdem vorgesehen sind - wenn die Anzahl von Auslösungsbefehlen einen vorher festgelegten Schwellenwert (Seuil_max) erreicht, während das Signal (Scomp) am Ausgang des Komparators (160) seinen zweiten Zustand aufrechterhält -, die Ladungsmenge (Qc) für wenigstens eine nachfolgende Ladungsinjektion zu erhöhen.

12. Mikroelektronische Bildsensor-Vorrichtung nach einem der Ansprüche 11 oder 12, bei der die Steuereinrichtungen (350) außerdem vorgesehen sind - wenn die gegebene Anzahl von aufeinanderfolgenden Auslösungsbefehlen der genannten Zustandswechsel niedriger oder gleich einem vorher festgelegten Schwellenwert (Seuil_max) ist, während das Signal (Scomp) am Ausgang des Komparators (160) in den ersten Zustand zurückkehrt -, die Ladungsmenge (Qc) für wenigstens eine nachfolgende Ladungsinjektion zu verringern.

13. Mikroelektronische Bildsensor-Vorrichtung nach einem der Ansprüche 1 bis 12, wobei der Detektor durch wenigstens ein Photodetektorelement gebildet wird.

14. Verfahren zur Steuerung einer mikroelektronischen Vorrichtung mit mindestens einem Detektor, mindestens einem Integrationskondensator, verbunden mit dem Detektor und fähig, mindestens ein analoges Signal zu liefern, das wenigstens in Abhängigkeit von einem durch den Detektor gelieferten Strom variabel ist, wobei das Verfahren die folgenden Schritt umfasst:
- das analoge Signal mit einer festgelegten Referenz zu vergleichen und ein 2-Zustände-Ausgangssignal (Scomp) zu liefern, das repräsentativ ist für den Vergleich und das einen "Stabilzustand" genannten ersten Zustand oder einen zweiten Zustand annehmen kann,
- in dem genannten 2-Zustände-Signal einen Übergang vom ersten Zustand in den zweiten Zustand zu detektieren,
- anschließend an die genannte Detektion eine oder mehrere Ladungsmenge(n) Qc in den Integrationskondensator zu injizieren,
wobei das Verfahren **dadurch gekennzeichnet ist, dass** es außerdem die folgenden Schritte umfasst:
- Durchführen einer Schätzung des durch den Detektor gelieferten Stroms,
- Durchführen eines Vergleichs des Resultats der genannten Schätzung mit wenigstens einem festgelegten Schwellenwert,
- Injizieren - anschließend an den genannten Vergleich - von einer oder von mehreren neue(n) gegebenen Ladungsmenge(n) Qc in den Kondensator, wobei die genannte oder die genannten neue(n) Ladungsmenge(n) in Abhängigkeit von dem Ergebnis des genannten Vergleichsschritts angepasst worden sind.

15. Steuerungsverfahren nach Anspruch 14, wobei die genannte Schätzung des durch den Detektor gelieferten Stroms wenigstens in Abhängigkeit von einer Injektionsfrequenz von Ladungen Qc realisiert wird.

16. Steuerungsverfahren nach Anspruch 14, wobei die genannte Schätzung wenigstens in Abhängigkeit von dem minimalen Pegel des analogen Signals realisiert wird.

17. Steuerungsverfahren nach einem der Ansprüche 14 bis 16, außerdem umfassend, anschließend an den genannten Zustandswechsel:
- das Senden - in Form eines anderen bzw. weiteren 2-Zustände-Signals - von einem oder mehreren Ladungsinjektionsbefehlen, solange das genannte 2-Zustände-Signal am Ausgang des Komparators seinen zweiten Zustand aufrechterhält, wobei die genannte Schätzung des durch den Detektor gelieferten Stroms wenigstens mit Hilfe einer Zählung der Anzahl gesendeter Auslösungsbefehle realisiert wird.

18. Verfahren nach Anspruch 17, bei dem - wenn die Anzahl von Auslösungsbefehlen einen vorher festgelegten Schwellenwert erreicht, während das Ausgangssignal des Komparators seinen zweiten Zustand aufrechterhält -, umfasst das Verfahren außerdem: eine Erhöhung der Ladungsmenge für wenigstens eine nachfolgende Ladungsinjektion.

19. Verfahren nach Anspruch 17 oder 18, bei dem - wenn die gegebene Anzahl der auf den genannten Zustandswechsel folgenden Auslösungsbefehle kleiner oder gleich einer vorher festgelegten Schwelle ist, wenn das Ausgangssignal des Komparators in den ersten Zustand zurückkehrt -, das Verfahren außerdem umfasst: eine Reduzierung der injizierten Ladungsmenge für wenigstens eine nachfolgende Ladungsinjektion.
